Europäisches Patentamt

European Patent Office

Office européen des brevets

(19)

(11) Numéro de publication : **0 159 931**
**B1**

(12)

# FASCICULE DE BREVET EUROPÉEN

(45) Date de publication du fascicule du brevet :
07.09.88

(51) Int. Cl.⁴ : **H 01 L 21/76**

(21) Numéro de dépôt : 85400627.7

(22) Date de dépôt : 29.03.85

(54) Procédé de fabrication de zones d'isolation électrique des composants d'un circuit intégré.

(30) Priorité : 30.03.84 FR 8405051

(43) Date de publication de la demande :
30.10.85 Bulletin 85/44

(45) Mention de la délivrance du brevet :
07.09.88 Bulletin 88/36

(84) Etats contractants désignés :
BE CH DE GB IT LI NL SE

(56) Documents cités :
EP-A- 0 072 966
EP-A- 0 091 507
US-A- 3 853 633
IBM TECHNICAL DISCLOSURE BULLETIN, vol. 25,
no. 12, mai 1983, pages 6611-6614, New York, US; S.A.
ABBAS et al.: "Simplified isolation for an integrated
circuit"

(73) Titulaire : **Bois, Daniel**
**9, rue de la Grange**
**F-38240 Meylan (FR)**

(72) Inventeur. : **Bois, Daniel**
**9, rue de la Grange**
**F-38240 Meylan (FR)**

(74) Mandataire : **Mongrédien, André et al**
**c/o BREVATOME 25, rue de Ponthieu**
**F-75008 Paris (FR)**

## Description

La présente invention a pour objet un procédé de fabrication de zones d'isolation électrique des composants d'un circuit intégré.

Ce procédé peut être utilisé dans le domaine de la microélectronique chaque fois qu'il est nécessaire d'isoler électriquement les uns des autres des composants (transistors, diodes, etc...) réalisés sur un support conducteur. Il s'applique donc plus particulièrement aux circuits intégrés utilisant le silicium comme substrat, tels que les circuits intégrés MOS ou bipolaires.

La recherche d'une forte densité d'intégration dans ce type de circuits intégrés nécessite d'utiliser une technique d'isolement particulière par diélectrique entre les différents composants.

On connaît actuellement trois grandes familles de techniques d'isolement par diélectrique.

Dans la première famille, l'isolement entre les composants est réalisé à la surface du circuit intégré par la réalisation de zones d'isolation obtenues par le dépôt d'un matériau isolant, généralement de l'oxyde de silicium. Cette technique présente des performances d'isolement médiocres compte tenu de la qualité de l'oxyde déposé. De plus, elle entraîne la formation de marches élevées sur la plaquette de circuit intégré à l'endroit des zones d'isolation, ce qui est gênant pour obtenir une forte densité d'intégration.

Par ailleurs, afin d'éviter la formation d'un canal conducteur parasite sous les zones d'isolation, il est nécessaire de doper localement les régions sous-jacentes correspondantes. Or, dans cette technique d'isolement, le dopage ne peut nullement être réalisé avec le même masque que celui servant à définir les zones d'isolation ; cette technique est donc une technique non autopositionnée. En conséquence, cette technologie est aujourd'hui pratiquement abandonnée pour la fabrication de circuits intégrés utilisant le silicium comme substrat.

Dans la deuxième famille, l'isolement entre les composants est réalisé au moyen d'un oxyde de silicium obtenu par oxydation localisée du substrat en silicium, à travers un masque. Ce masque sert aussi, avant oxydation du substrat, à délimiter les zones du substrat dans lesquelles on réalise un dopage permettant d'éliminer la possibilité de formation d'un canal parasite sous les régions oxydées. Cette technique est donc une technique autopositionnée.

Cette technologie connue sous le nom de technologie LOCOS (oxydation localisée) représente, aujourd'hui, la technique d'isolement standard dans les circuits intégrés utilisant le silicium comme substrat. Cependant, cette technologie requiert la fabrication de zones d'isolation de 4 à 7 μm de large, ce qui limite considérablement la densité d'intégration.

Par ailleurs, dans les variantes les plus modernes de cette technique d'isolement, il n'est possible de réaliser des isolements que sur une profondeur de 1 μm. En outre, l'obtention d'un isolement à une telle profondeur n'est possible qu'en réalisant une oxydation thermique à haute température, ce qui n'est pas sans inconvénient.

Dans la dernière famille, on réalise l'isolement entre les composants en ouvrant des tranchées dans le substrat, tranchées que l'on vient ensuite remplir par un matériau isolant. Ce remplissage se fait par dépôt de l'isolant sur toute la surface du circuit intégré suivi d'un enlèvement de l'excédent d'isolant déposé hors des tranchées. L'excédent d'isolant peut être enlevé soit par gravure (chimique ou plasma), soit par la technique de « lift-off » en terminologie anglo-saxonne. Cette technique d'isolement a notamment été décrite dans un article IEDM de 1982, pages 237 à 240, intitulé « Deep Trench Isolated CMOS Devices ».

Cette technique de tranchées permet d'atteindre de grandes profondeurs d'isolation (plusieurs μm) avec un encombrement latéral ne dépassant pas le micromètre. En revanche, cette technique ne résout pas le problème clé de formation de canaux parasites sous les zones d'isolation et sur les bords des tranchées.

La présente invention a justement pour objet un procédé de fabrication de zones d'isolation électrique des composants d'un circuit intégré permettant de remédier aux inconvénients cités précédemment. Ce procédé, basé sur la réalisation de tranchées et d'une oxydation localisée, permet d'éviter la formation de canaux parasites sous les zones d'isolation et sur les bords des tranchées tout en conservant les principaux avantages des techniques correspondantes.

De façon plus précise, l'invention a pour objet un procédé de fabrication de zones d'isolation permettant d'isoler électriquement entre eux les composants d'un circuit intégré réalisés sur un substrat en silicium, comprenant les étapes successives suivantes :

— réalisation d'un masque sur le substrat pour définir les emplacements des zones d'isolation à réaliser, ce masque étant en un matériau permettant une oxydation localisée du substrat sous-jacent,

— dopage des régions du substrat non masquées,

— oxydation thermique desdites régions du substrat,

— réalisation d'une tranchée dans chaque région oxydée du substrat, et dans les régions du substrat situées au-dessous desdites régions oxydées, en utilisant ledit masque,

— oxydation thermique des bords des tranchées,

— remplissage des tranchées par un matériau isolant, et

— élimination du masque.

Dans ce procédé, les tranchées remplies d'isolant permettent d'obtenir des isolations en profondeur, alors que l'oxydation thermique localisée des régions du substrat non masquées permet de réaliser un isolement à la surface du substrat en silicium, comme le procédé LOCOS de l'art antérieur. Cette isolation en surface est notamment due à l'autopositionnement (même masque) de l'oxydation localisée et du dopage des régions non masquées du substrat.

Au cas où de l'isolant se trouverait hors des tranchées, celui-ci devra être, conformément à l'invention, éliminé notamment par gravure.

Selon un mode préféré de mise en œuvre du procédé de l'invention, le dopage des régions du substrat non masquées est réalisé par implantation ionique.

Selon un autre mode préféré de mise en œuvre du procédé de l'invention, le remplissage des tranchées est réalisé par dépôt par exemple par la technique de dépôt chimique en phase vapeur (CVD).

De façon avantageuse, le matériau isolant est de l'oxyde de silicium ou du silicium polycristallin.

D'autres caractéristiques et avantages de l'invention ressortiront mieux de la description qui va suivre, donnée à titre explicatif et non limitatif en référence aux figures annexées selon lesquelles :

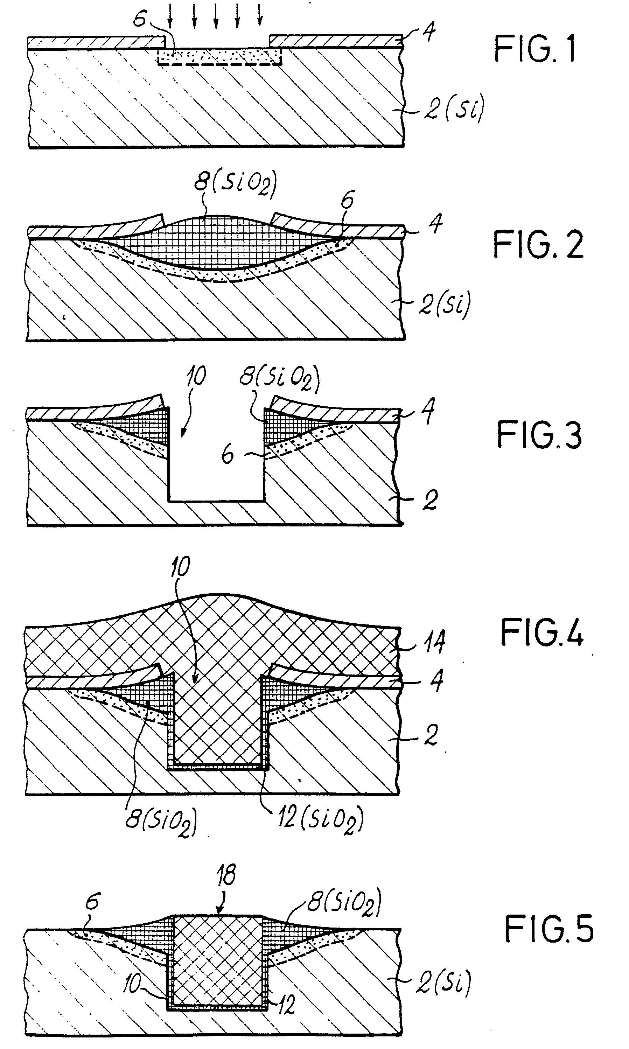

— les figures 1 à 5 représentent schématiquement, en coupe longitudinale, les différentes étapes du procédé, conformément à l'invention.

Pour simplifier les figures, on n'a représenté qu'une seule zone d'isolation.

En se référant à la figure 1, la première étape du procédé selon l'invention consiste à réaliser, sur un substrat en silicium monocristallin 2, par exemple de type p, d'orientation 100 et de conductivité comprise entre 20 et 40 $\Omega$.cm, un masque 4, par exemple en nitrure de silicium ($Si_3N_4$) de 200 nm (2 000 Å) d'épaisseur. Ce masque 4 permet de définir les emplacements des zones d'isolation à réaliser, c'est-à-dire qu'il permet de masquer toute la surface du substrat, excepté aux endroits où les zones d'isolation sont prévues.

L'étape suivante du procédé consiste à réaliser, à travers le masque 4, un dopage du substrat 2 aux endroits où les zones d'isolation sont prévues. Les régions dopées du substrat 2 portent la référence 6. Ce dopage peut être réalisé par une implantation ionique schématisée par les flèches, par exemple à l'aide d'ions de bore à une énergie de 50 KeV et à une dose de $10^{13}$ atomes par cm². Ce dopage permet d'éliminer la possibilité de formation d'un canal parasite au niveau des zones d'isolation à réaliser.

Après ce dopage, on réalise une oxydation thermique localisée du substrat, c'est-à-dire une oxydation des régions du substrat dopées 6 à travers le masque 4. Cette oxydation peut être réalisée à 1 000 °C pendant une heure et sur une épaisseur de 300 nm (3 000 Å). Elle permet la formation comme représenté sur la figure 2, de régions isolantes telles que 8 en oxyde de silicium, ainsi qu'une redistribution du dopage sous ces régions isolantes 8. Ces régions 8 permettent d'assurer une isolation en surface des composants du circuit intégré.

L'étape suivante du procédé consiste à réaliser, comme représenté sur la figure 3, des tranchées 10 dans les régions oxydées 8 du substrat, ainsi que dans les régions du substrat situées en-dessous desdites régions oxydées. Ces tranchées 10, présentant une largeur et une profondeur de l'ordre du micromètre, peuvent être obtenues en gravant, par exemple à l'aide d'un plasma, les zones oxydées 8 et le substrat sous-jacent à travers le masque 4. Cette gravure peut notamment être réalisée à l'aide d'un mélange de tétrachlorure de carbone ($CCl_4$) et d'oxygène.

Après cette gravure, on oxyde thermiquement, par exemple à une température de 950 °C pendant une heure, les bords des tranchées 10. Cette oxydation permet d'obtenir un film d'oxyde 12, comme représenté sur la figure 4, ayant une épaisseur de 100 nm (1 000 Å). Ensuite, on remplit les tranchées 10 par un diélectrique isolant 14, comme par exemple de l'oxyde de silicium ou du silicium polycristallin non dopé. Ce remplissage des tranchées peut être réalisé par dépôt notamment par la technique de dépôt chimique en phase vapeur à une température de l'ordre de 600 °C. Les tranchées 10 remplies d'isolant permettent d'assurer une bonne isolation latérale et en profondeur entre les différents composants du circuit intégré.

Ensuite, comme représenté sur la figure 5, on élimine l'excédent d'isolant 14 se trouvant hors des tranchées 10 par exemple par un procédé dit de planarisation. Ce procédé consiste à déposer une couche de résine, telle que celles couramment utilisées en photolithogravure, sur l'isolant 14 et à attaquer la résine et l'isolant à l'aide d'une gravure ionique réactive, par exemple à l'aide d'un mélange de trifluorure de carbone ($CHF_3$) et de 10 % en volume d'oxygène avec une puissance d'excitation de 100 W. Ensuite, on enlève le masque de nitrure de silicium 4, par exemple par une gravure chimique. La gravure du masque, lorsqu'il est réalisé en $Si_3N_4$, peut notamment être réalisée à chaud à l'aide de l'acide phosphorique ($H_3PO_4$).

L'emploi d'un même masque 4 pour réaliser les différentes étapes d'oxydation et de dopage du procédé permet un auto-positionnement des zones d'isolation 18 et des régions dopées 6 du substrat. Cet auto-positionnement permet de limiter l'encombrement des zones d'isolation, ce qui est très important pour les circuits intégrés de haute densité d'intégration.

Les zones d'isolation 18, permettant d'isoler électriquement les différents composants d'un circuit intégré, sont constituées par le reste des régions oxydées 8 du substrat, après gravure, le mince film d'oxyde 12, réalisé sur le bord de tranchée 10, et l'isolant 14 remplissant lesdites tranchées.

Le procédé selon l'invention permet d'obtenir des zones d'isolation 18 ayant des encombrements latéraux ne dépassant pas le micromètre, mais ayant une profondeur de plusieurs micromètres.

## Revendications

1. Procédé de fabrication de zones d'isolation (18) permettant d'isoler électriquement entre eux les composants d'un circuit intégré réalisés sur un substrat en silicium (2), comprenant les étapes successives suivantes :

— réalisation d'un masque (4) sur le substrat (2) pour définir les emplacements des zones d'isolation (18) à réaliser, ce masque étant en un matériau permettant une oxydation localisée du substrat sous-jacent,

— dopage des régions (6) du substrat non masquées,

— oxydation thermique desdites régions du substrat,

— réalisation d'une tranchée (10) dans chaque région oxydée (8) du substrat, et dans les régions du substrat situées au-dessous desdites régions oxydées, en utilisant ledit masque,

— oxydation thermique des bords des tranchées (10),

— remplissage des tranchées (10) par un matériau (14) isolant, et

— élimination du masque (4).

2. Procédé de fabrication selon la revendication 1, caractérisé en ce que l'on élimine l'isolant (14) excédent se trouvant hors des tranchées (10).

3. Procédé de fabrication selon l'une quelconque des revendications 1 et 2, caractérisé en ce que le dopage est réalisé par implantation ionique.

4. Procédé de fabrication selon l'une quelconque des revendications 1 à 3, caractérisé en ce que le remplissage des tranchées (10) est réalisé par dépôt.

5. Procédé de fabrication selon l'une quelconque des revendications 1 à 4, caractérisé en ce que le matériau isolant (14) est de l'oxyde de silicium ou de silicium polycristallin.

6. Procédé de fabrication selon l'une quelconque des revendications 1 à 5, caractérisé en ce que l'on réalise les tranchées (10) par gravure.

7. Procédé de fabrication selon la revendication 2, caractérisé en ce que l'on élimine le diélectrique isolant (14) excédent par gravure.

## Claims

1. Process for the production of isolation zones (18) making it possible to bring about electrical isolation between the components of an integrated circuit formed on a silicon substrate (2) comprising the stages of forming a mask (4) on the substrate (2) in order to define the locations of the isolation zones (18) to be produced, said mask being of a material permitting a local oxidation of the underlying substrate, doping the unmasked substrate regions (6), thermal oxidation of said substrate regions, formation of a trench (10) in each oxidised region (8) of the substrate and in the substrate regions positioned below said oxidised regions and using the same mask, thermal oxidation of the edges of the trenches (10), filling the trenches (10) with an isolating material (14) and elimination of the mask (4).

2. Production process according to Claim 1, characterized in that the excess isolation material (14) outside the trenches (10) is eliminated.

3. Production process according to either of the claims 1 and 2, characterized in that doping is carried out by ion implantation.

4. Production process according to any one of the claims 1 to 3, characterized in that the trenches (10) are filled by deposition.

5. Production process according to any one of the claims 1 to 4, characterized in that the isolating material (14) is silicon oxide or crystalline silicon.

6. Production process according to any one of the claims 1 to 5, characterized in that the trenches (10) are produced by etching.

7. Production process according to claim 2, characterized in that the excess isolating dielectric (14) is eliminated by etching.

## Patentansprüche

1. Verfahren für die Herstellung von Isolierzonen (18), das die elektrische Isolierung zwischen den Bauelementen eines integrierten Schaltkreises auf einem Siliciumsubstrat (2) ermöglicht und die folgenden aufeinanderfolgenden Etappen umfaßt :

— Herstellung einer Maske (4) auf dem Substrat (2) zur Festlegung der Stellen für die anzubringenden Isolierzonen (18), wobei die Maske aus einem Material besteht, das eine lokalisierte Oxidation des darunterliegenden Substrats ermöglicht.

— Doping der nicht maskierten Bereich (6) des Substrats.

— Thermische Oxidation der besagten Bereiche des Substrats.

— Durchführung von Einschnitten bzw. Ausnehmungen (10) in jeder oxidierten Zone (8) des Substrats und in den unter den besagten oxidierten Zonen liegenden Bereichen des Substrats unter Verwendung der genannten Maske.

— Thermische Oxidation der Ränder der Einschnitte (10).

— Füllung der Einschnitte (10) mit einem Isoliermaterial (14) und

— Entfernung der Maske (4).

2. Herstellungsverfahren nach dem Patentanspruch 1, dadurch gekennzeichnet, daß die überschüssige Isolierung (14) außerhalb der Einschnitte (10) entfernt wird.

3. Herstellungsverfahren nach einem der Patentansprüche 1 und 2, dadurch gekennzeichnet, daß das Doping durch Ionenimplantation geschieht.

4. Herstellungsverfahren nach einem der Patentansprüche 1 bis 3, dadurch gekennzeichnet, daß die Füllung der Einschnitte (10) durch Depot erfolgt.

5. Herstellungsverfahren nach einem der Patentansprüche 1 bis 4, dadurch gekennzeichnet, daß das Isoliermaterial (14) aus Siliciumoxid oder aus polykristallinem Silicium besteht.

6. Herstellungsverfahren nach einem der Patentansprüche 1 bis 5, dadurch gekennzeichnet, daß die Einschnitte (10) durch Ätzung erfolgen.

7. Herstellungsverfahren nach dem Patentanspruch 2, dadurch gekennzeichnet, daß der überschüssige isolierende Nichtleiter (14) durch Ätzung entfernt wird.

0 159 931

6 ↓↓↓↓↓
4
FIG.1
2(Si)

8(SiO₂)
6
4
FIG.2
2(Si)

10   8(SiO₂)
4
6
FIG.3
2

10
14
4
2
FIG.4
8(SiO₂)   12(SiO₂)

18
6   8(SiO₂)
FIG.5
10   12
2(Si)

1